(19) Europäisches Patentamt
European Patent Office
Office européen des brevets

(11) EP 3 185 397 A1

(12) EUROPEAN PATENT APPLICATION

(43) Date of publication:
28.06.2017 Bulletin 2017/26

(51) Int Cl.:
H02J 50/12 (2016.01)     H03F 1/56 (2006.01)
H03F 3/217 (2006.01)

(21) Application number: 16198756.5

(22) Date of filing: 14.11.2016

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME
Designated Validation States:
MA MD

(30) Priority: 24.12.2015 US 201514757914

(71) Applicant: Intel Corporation
Santa Clara, CA 95054 (US)

(72) Inventors:
• YANG, Songnan
San Jose, CA California 95123 (US)
• XIAO, Bin
San Ramon, CA California 94582 (US)
• CHEN, Jian
Shanghai, 200241 (CN)
• KASTURI, Sreenivas
Hillsboro, OR Oregon 97124 (US)
• MASLOV, Jordan E.
Hillsboro, OR Oregon 97124 (US)

(74) Representative: Goddar, Heinz J. et al
BOEHMERT & BOEHMERT
Anwaltspartnerschaft mbB
Pettenkoferstrasse 20-22
80336 München (DE)

(54) REACTANCE SHIFT DETECTION IN A WIRELESS POWER TRANSMITTER

(57) Techniques for tuning in a wireless power transmitter in a system, method, and apparatus are described herein. An example of a wireless power transmitter may include a transmitter coil configured to generate a magnetic field for wirelessly charging a battery, and a tuning circuit coupled to the transmitter coil configured to retune the transmitter coil in response to a reactance shift of the transmitter coil. The wireless power transmitter may also include a tuning control circuit to detect the reactance shift and control the tuning circuit to retune the transmitter coil. The tuning control circuit is to detect the reactance by measuring a drain voltage of a power amplifier.

102
FIG. 2

## Description

### Technical Field

This disclosure relates generally to techniques for wireless charging. Specifically, this disclosure relates to tuning a wireless power transmitter.

### Background Art

A basic wireless charging system may include a wireless power transmitter unit (PTU) and a wireless power receiving unit (PRU). For example, a PTU may include a transmit (Tx) coil, and a PRU may include receive (Rx) coil. Magnetic resonance wireless charging may employ a magnetic coupling between the Tx coil and the Rx coil. In some cases, a PRU is implemented in a device having various size chassis. In some cases, constant current supply design may include providing a constant current source even when various PRU device chassis size changes the resonant frequency of the PTU coil.

### Brief Description of the Drawings

Fig. 1 is block diagram of a power transmitting unit to provide power to a power receiving unit.
Fig. 2 is a diagram illustrating an example of a tuning control circuit.
Fig. 3 is a plot of the electrical characteristics of the power amplifier (PA) plotted on a smith chart.
Fig. 4 is a plot of the power amplifier drain voltage wave form plotted over variable load reactance shift conditions.
Fig. 5 is a process flow diagram of an example method to control a tuning circuit of a wireless power transmitting unit.

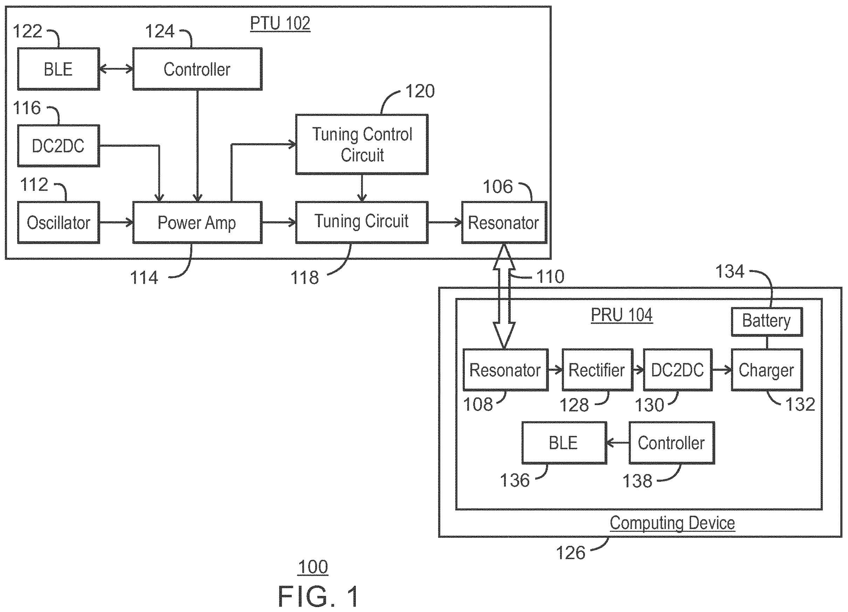

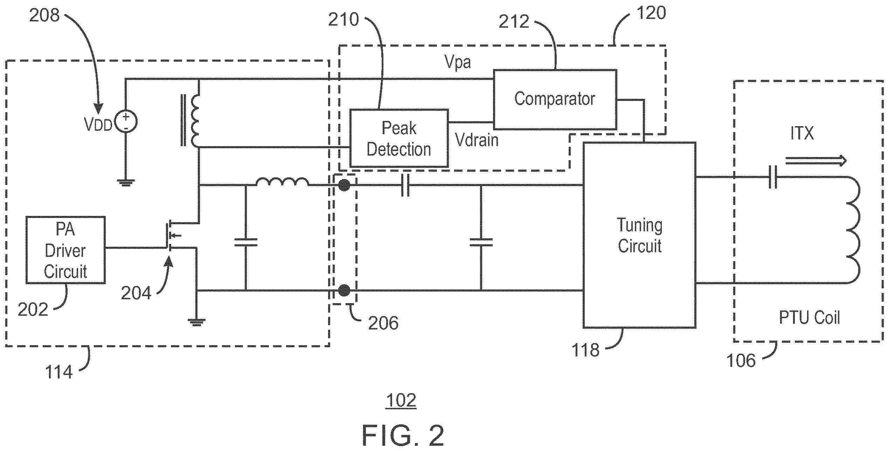

The same numbers are used throughout the disclosure and the figures to reference like components and features. Numbers in the 100 series refer to features originally found in Fig. 1; numbers in the 200 series refer to features originally found in Fig. 2; and so on.

### Description of the Aspects

The present disclosure relates generally to techniques for wireless charging. Specifically, the techniques described herein provide a wireless power transmitting unit (PTU) having a transmit (Tx) coil configured to generate a magnetic field. The PTU includes a tuning circuit that impedance matches the output of a power source to the input of the transmit coil. The tuning circuit is responsive to a change in the impedance of the transmit coil, for example, a change in the reactance of the transmit coil.

As discussed above, in some cases, constant current supply design may include providing a constant current source even while PRU devices with various chassis sizes may be presented to the PTU coil and change the resonant frequency of the PTU coil, which in turn degrades the coupling condition between PTU and PRU. For example, a mobile computing device having a PRU may have a relatively smaller metal chassis when compared to a laptop computing device. When a computing device having a relatively larger metal chassis is placed on a wireless charging device having a PTU, a reduction of PTU coil inductance may occur as an eddy current induced on the metal chassis cancels part of the magnetic field generated by PTU, causing a detuning, or reactance shift from the resonant frequency. This detuning effect significantly reduces the efficiency of the power amplifier (PA) and its capability to provide a constant current to the resonator coil, and in extreme cases it may damage the power amplifier.

The tuning circuit can include circuitry for retuning the transmit coil and the magnetic coupling between the PTU and PRU to the same resonant frequency, such as a set of capacitors configured to generate a reactance shift to counter the detected reactance shift caused by the presence of PRU devices. As the reactance shifts, additional capacitors can be engaged to counter the shift. In some situations, reactance shifts may occur rapidly. Therefore, the circuitry used to detect the reactance shift and engage the tuning should be able to respond to quickly changing conditions.

According to one technique for detecting the reactance shift, a voltage sensor, a current sensor, and a phase detector are used to measure the electrical characteristics of load. These measurements are input to a microcontroller, which digitizes the input and computes the load impedance. The micro controller determines whether to adjust the tuning circuit based on the reactance component of the calculated impedance value. Since this technique relies on the microcontroller to calculate the reactance shift, it may not be fast enough to handle fast varying reactance variation on the PTU coil when a large device such as a notebook computer or tablet PC is placed on or removed from the PTU coil.

The techniques described herein enable the reactance shifts of the PTU transmit coil to be detected more quickly. The reactance shifts are detected directly without the use of digitization and calculation by a microcontroller. The proposed technique is therefore faster and simpler to implement.

In some cases, the techniques discussed herein may be implemented using a wireless charging standard protocol, such as the specification provided by Alliance For Wireless Power (A4WP) version 1.3, November 05, 2014. A wireless power receiving (Rx) coil may be a component in a power receiving unit (PRU), while a wireless power transmission (Tx) coil may be a component in a power transmitting unit (PTU), as discussed in more detail below. However, the techniques described herein may be implemented using any other wireless charging standard protocol where applicable.

Fig. 1 is block diagram of a PTU to provide power to a PRU. A PTU 102 may be coupled to a PRU 104 via magnetic inductive coupling between resonators 106 and 108, as indicated by the arrow 110. The resonator 106 of the PTU 102 may be referred to herein as a Tx coil 106. The resonator 108 of the PRU 104 may be referred to herein as an Rx coil 108.

The PTU 102 may include an oscillator, 112, a power amplifier 114, a Direct Current to Direct Current (DC2DC) converter 116, and a tuning circuit 118. The oscillator 112 is configured to generate a periodic oscillating electronic signal at a specified frequency. The power amplifier 114 receives direct current power from the DC2DC converter 116, and amplifies the signal received from the oscillator 112. The power amplifier 114 may be a switching power amplifier such as a Class E amplifier.

The tuning circuit 118 matches the impedance of the power amplifier 114 to the impedance of the resonator 106 to ensure efficient power transmission. The tuning circuit 118 may include any suitable arrangement of electrical components such as capacitors, inductors, and other circuit elements that can be adjusted to impedance match the resonator 106 to the power amplifier 114. The tuning circuit 118 is controlled by the tuning control circuit 120, which is discussed further below.

Other components of the PTU may include a Bluetooth Low Energy (BLE) module 122, a controller 124, and others. The controller 124 can be configured to control various aspects of the operation of the PTU 102. For example, the controller 124 can set a frequency, and/or power level of the power radiated by the resonator 106. The controller 124 can also control communications between the PTU 102 and the PRU 104 through the BLE module 122.

The PRU 104 may be a component of a computing device 126 configured to receive power from the PTU 102 wirelessly by the inductive coupling 110. The computing device 126 may be any suitable type of computing device, including a laptop computer, an Ultrabook, a tablet computer, a phablet, a mobile phone, smart phone, smart watch, and other types of mobile battery-powered devices.

The PRU 104 can include a rectifier 128, a DC2DC converter 130, a battery charger 132, and a battery 134. The computing device 126 receives electrical power as a magnetic flux associated with the inductive coupling that passes through the resonator 108. The rectifier 128 receives an alternating current (AC) voltage from the resonator 108 and generates a rectified DC voltage (Vrect). The DC2DC converter 130 receives the rectified voltage from the rectifier 128, converts the voltage to a suitable voltage level, and provides the output to the battery charger 132, which charges the battery 134. The battery 134 powers the various platform hardware of the computing device 126. The platform hardware includes all of the processors, working memory, data storage devices, communication buses, I/O interfaces, communication devices, display devices, and other components that make up the computing device 126.

The PRU 104 may also include a Bluetooth Low Energy (BLE) module 136 and a controller 138. The controller 138 is configured to perform a wireless handshake with the PTU 102. As discussed above, the wireless handshake broadcast may be performed through the BLE modules 122 and 136 or other wireless data transmission component. Various types of information may be transmitted during the wireless handshake, including power budget, wireless charging capabilities, size of the computing device 126, and other information.

The tuning control circuit 120 is configured to sense a reactance shift of the resonator 106 occurring due to inductive coupling between the PTU 102 and other objects, such as the PRU 104. Upon detection of a reactance shift above a predefined threshold, the tuning control circuit 120 can adjust the tuning circuit 118 to retune the magnetic inductive coupling 110 to a resonant frequency. The tuning control circuit 120 can include one or more voltage sensor, current sensors, comparators, and other simply circuitry for generating a tuner control signal and sending the tuner control signal to the tuning circuit. The tuning control circuit 120 may not include an Analog-to-Digital Converter (ADC), a microcontroller, or other type of processors for performing complex mathematical computations. Examples of a tuning control circuit 120 are described further below.

The block diagram of Fig. 1 is not intended to indicate that the PTU 102 and the PRU 104 are to include all of the components shown in Fig. 1. Further, the PTU 102 and/or the PRU 104 may include any number of additional components not shown in Fig. 1, depending on the details of the specific implementation.

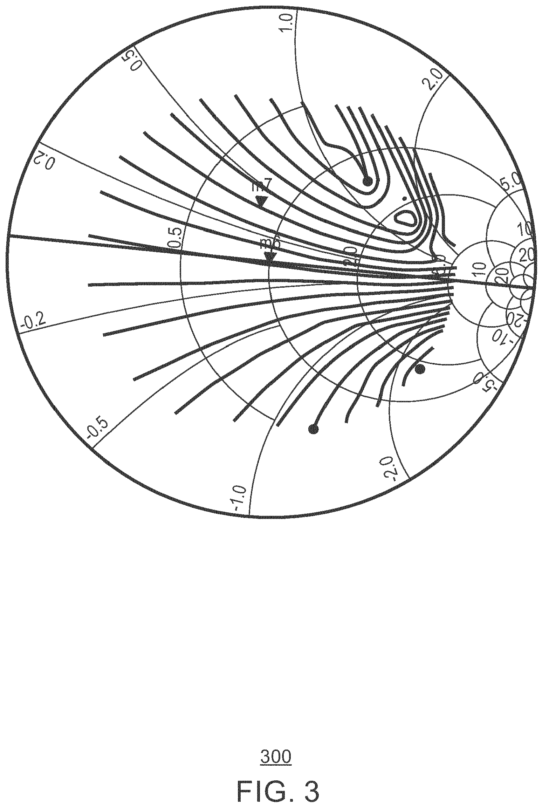

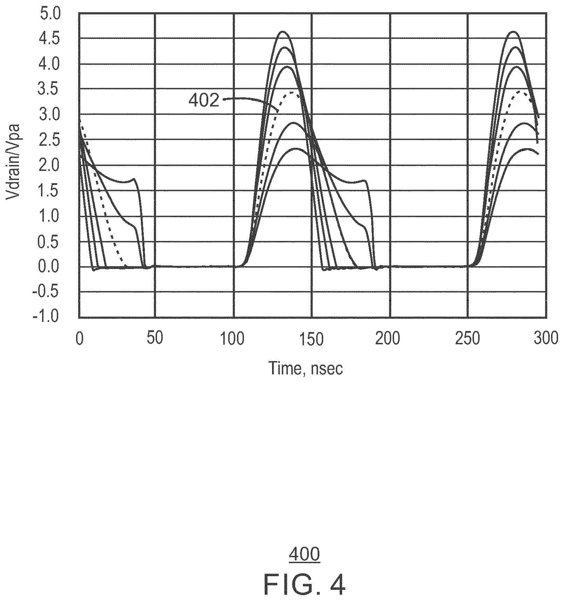

Fig. 2 is a diagram illustrating an example of a tuning control circuit. As shown in Fig. 2, the tuning control circuit 120 is coupled to the power amplifier 114. The power amplifier 114 includes a power amplifier driver circuit 202 coupled to a switch 204, such as a bipolar transistor, Field Effect Transistor (FET), or other type of switch. The power amplifier 114 pulses the switch 204 to create a voltage at the output 206 of the power amplifier 114. The output 206 of the power amplifier 114 is an alternating current (AC) that oscillates at the desired frequency of the power amplifier. The power supply for the switch 204 is provided by the voltage source 208, $V_{DD}$. The duty cycle of the pulse pattern generated by the power amplifier driver determines the magnitude of the output voltage. In some examples, the power amplifier 114 is a class E power amplifier, which is configured to exhibit the electrical characteristics described in Figs. 3 and 4 below.

The tuning control circuit 120 can include a peak detection circuit 210 and a comparator 212. The peak detection circuit 210 measures the peak drain voltage at the drain terminal of the switch 204, wherein the peak voltage is the highest absolute voltage magnitude that is exhibited during one period. The peak drain voltage is referred to herein as $V_{drain}$. In some examples, the peak detection circuit may be implemented as a diode or a capacitor. The comparator 212 measures the DC supply voltage, $V_{DD}$, and compares it to the peak drain voltage, $V_{drain}$, to generate a tuning control signal, which is sent to the tuning circuit.

As explained further below, the power amplifier 114 is configured so that the ratio between peak drain voltage (Vdrain) and DC supply voltage to the power amplifier (Vpa) directly reflects the reactance shift (jX) of the load. In some examples, the power amplifier 114 is operated with zero voltage switching (ZVS) and zero voltage differential switching with 50 percent duty cycle. Once the load impedance exceeds a specified reactance shift threshold (jXth), as indicated by the ratio between Vdrain and Vpa exceed a specific value, the output of the comparator 212 directly addresses the tuning circuit 118 to switch in additional capacitance to compensate for the reactance shift.

If the ratio between peak Vdrain and Vpa exceeds a specified upper threshold, a capacitive loading condition is detected, such as a large metallic chassis device coming into the charging field. In this case, the tuning signal drives the tuning circuit to switch in additional capacitors to compensate for the reactance shift. If the ratio between peak Vdrain and Vpa falls below a specified lower threshold, an inductive loading condition is detected, such as a large metallic chassis device is removed from the charging field. In this case, the tuning signal drives the tuning circuit to switch out capacitors to compensate for the reactance shift. In this way, the circuit directly determines the reactance shift (jX) through comparing two analog voltages, which does not require complex sensing circuitry or microcontroller. It can be implemented completely by simple logic hardware, which is inherently faster and more robust.

The block diagram of Fig. 2 is not intended to indicate that the PTU 102 is to include all of the components shown in Fig. 2. Further, the PTU 102 may include any number of additional components not shown in Fig. 2, depending on the details of the specific implementation.

Fig. 3 is a plot of the electrical characteristics of the power amplifier plotted on a smith chart. Each curve represents a constant peak drain voltage contour line for the power amplifier under different loading conditions of the transmit coil 106 shown in Fig 2. Each contour line represents the complex load impedances that gives the same Peak Drain node voltage. As can be seen in the smith chart of Fig. 3, the constant peak drain voltage contour lines are very closely aligned with the reactance axis, also known as constant jX lines, of the smith chart. Accordingly, the reactance shift (jX) can be directly detected by measuring the drain voltage. Thus, the drain voltage, $V_{drain}$, relative to the supply voltage, $V_{DD}$, can be used as a direct indication of the reactance level exhibited by the load.

Fig. 4 is a plot of the drain voltage wave form plotted over variable load reactance shift conditions. The plot of Fig. 4 is a simulated voltage waveform for the power amplifier 114 shown in Fig. 2. If the power amplifier 114 is operated with zero voltage switching (ZVS) and zero voltage differential switching with 50 percent duty cycle, the ideal switch mode voltage waveform (ideal Vdrain) can be expressed as:

$$Vdrain/Vpa = \begin{cases} 0, & \text{for } 0 < \omega t < \pi \\ \pi/2\sin \omega t - \cos \omega t +1, & \text{for } \pi < \omega t < 2\pi \end{cases}$$

The ideal switch mode voltage waveform 402 is shown with dotted lines and represents a load condition with zero reactance. When the load deviates from its ideal (zero reactance) condition, the power amplifier 114 may behave one of two ways. The load change may either disrupt the power amplifiers Zero Voltage Switching (ZVS) condition, in which case the peak drain voltage is lower than the ideal case, or it could allow the body diode of the switching transistor to turn on, in which case the peak drain voltage is much higher than the ideal case. Thus, the peak drain voltage provides a direct indication of the reactance shift (jX), such that the ratio between peak $V_{drain}$ and $V_{DD}$ can be used to detect reactance shift (jX).

As shown in Fig. 4, the power amplifier may exhibit similar peak $V_{drain}$ characteristics over a large range of supply voltages. As shown in Fig. 4, the $V_{drain}$ wave form is plotted over variable load reactance shift conditions. As can be seen in Fig. 4, with proper power amplifier design, the non-ZVS conditions are aligned with all inductive load (+jX), where the more inductive the load is, the lower the peak $V_{drain}$ and $V_{DD}$ ratio becomes. Similarly, the body diode conduction conditions are aligned with all capacitive load conditions (-jX), where the more capacitive the load is, the higher the peak $V_{drain}$ and $V_{DD}$ ratio becomes. In general, in wide range of load and supply conditions, the peak $V_{drain}$ to $V_{DD}$ ratio monotonically increases as the reactance of load (jX) increases, and it can be used for hardware based reactance shift detection for controlling a tuning circuit.

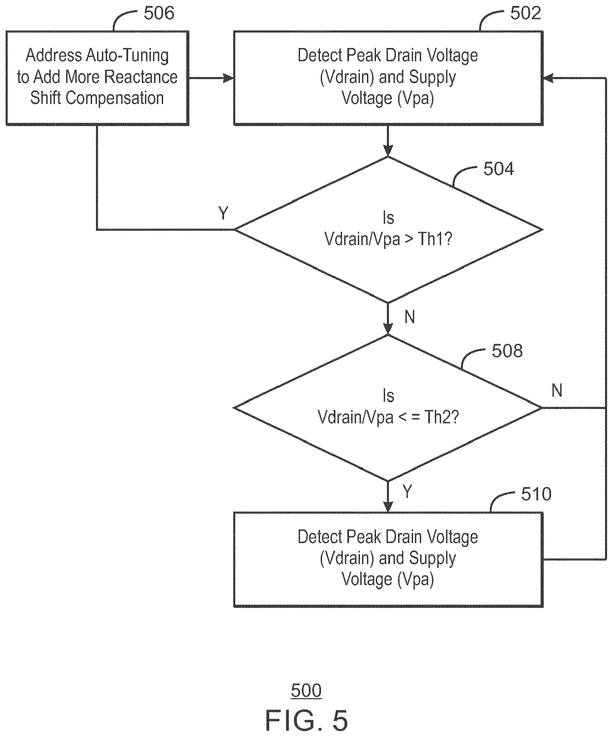

Fig. 5 is a process flow diagram of an example method to control a tuning circuit of a wireless power transmitting unit. The method 500 may be performed by the tuning control circuit 120 shown in Figs. 1 and 2. The method 500 may be implemented by logic embodied in hardware, such simple electrical components including capacitors, diodes, logic gates, latches, and others. The method may start at block 502.

At block 502, the peak drain voltage, $V_{drain}$, is detected. As explained above, the peak drain voltage is the peak voltage magnitude at the drain of the power amplifier switch over one period of the AC waveform.

At block 504, the ratio of the peak drain voltage, $V_{drain}$, over the DC supply voltage to the power amplifier, $V_{DD}$, is compared to an upper threshold of the ratio, $Th_1$. For example, the upper threshold of the ratio may be approximately 4.5. If the ratio of the peak drain voltage, $V_{drain}$, over the DC supply voltage to the power amplifier, $V_{DD}$, is greater than the upper ratio threshold, the process flow advances to block 506.

At block 506, the tuning circuitry is addressed to add more reactance shift compensation. To add more reactance shift compensation, the tuning circuitry may engage or disengage one or more tuning elements to reduce the reactance closer to zero. In the case of capacitive tuning elements, for example, adding additional capacitors will increase the reactance. The process flow then returns to block 502.

At block 504, if the ratio of the peak drain voltage, $V_{drain}$, over the DC supply voltage to the power amplifier, $V_{DD}$, is not greater than the upper reactance threshold, the process flow advances to block 508.

At block 508, the ratio of the peak drain voltage, $V_{drain}$, over the DC supply voltage to the power amplifier, $V_{DD}$, is compared to a lower threshold, $Th_2$. For example, the lower reactance threshold may be approximately 2.5. If the ratio of the peak drain voltage, $V_{drain}$, over the DC supply voltage to the power amplifier, $V_{DD}$, is less than the lower threshold, the process flow advances to block 510.

At block 510, the tuning circuitry is addressed to add more reactance shift compensation. As mentioned above, to add more reactance shift compensation, the tuning circuitry may engage or disengage one or more tuning elements to reduce the reactance closer to zero. In the case of capacitive tuning elements, for example, removing capacitors will reduce the reactance. The process flow then returns to block 502.

The method 500 should not be interpreted as meaning that the blocks are necessarily performed in the order shown. Furthermore, fewer or greater actions can be included in the method 500 depending on the design considerations of a particular implementation.

*Examples*

Example 1 is a wireless power transmitter that is re-tunable based on detecting a reactance shift. The wireless power transmitter includes a transmitter coil configured to generate a magnetic field for wirelessly charging a battery; a tuning circuit coupled to the transmitter coil configured to retune the transmitter coil in response to a reactance shift of the transmitter coil; and a tuning control circuit to detect the reactance shift and control the tuning circuit to retune the transmitter coil, the tuning control circuit to detect the reactance shift by measuring a drain voltage of a power amplifier.

Example 2 includes the wireless power transmitter of example 1, including or excluding optional features. In this example, the drain voltage is compared to a supply voltage of the power amplifier to determine the reactance shift.

Example 3 includes the wireless power transmitter of any one of examples 1 to 2, including or excluding optional features. In this example, the power amplifier is a switch mode power amplifier.

Example 4 includes the wireless power transmitter of any one of examples 1 to 3, including or excluding optional features. In this example, the power amplifier is a class E switch mode power amplifier.

Example 5 includes the wireless power transmitter of any one of examples 1 to 4, including or excluding optional features. In this example, the tuning control circuit controls the tuning circuit to retune the transmitter coil if the drain voltage is above an upper threshold or below a lower threshold. Optionally, the tuning control circuit controls the tuning circuit to add capacitive tuning elements to the tuning circuit if the drain voltage is above the upper threshold. Optionally, the tuning control circuit controls the tuning circuit to remove capacitive tuning elements to the tuning circuit if the drain voltage is below the lower threshold.

Example 6 includes the wireless power transmitter of any one of examples 1 to 5, including or excluding optional features. In this example, the tuning control circuit is independent of a processor.

Example 7 includes the wireless power transmitter of any one of examples 1 to 6, including or excluding optional features. In this example, the tuning control circuit is independent of a digital representation of the drain voltage.

Example 8 includes the wireless power transmitter of any one of examples 1 to 7, including or excluding optional features. In this example, the tuning control circuit is independent of an impedance of the transmitter coil.

Example 9 is a method of re-tuning a transmit coil based on detecting a reactance shift. The method includes generating, via a transmit coil, a magnetic field for wirelessly powering an electronic device; detecting a reactance shift of the transmit coil by measuring a drain voltage of a power amplifier that provides power to the transmit coil; and controlling a tuning circuit to retune the transmit coil based on the reactance shift.

Example 10 includes the method of example 9, including or excluding optional features. In this example, detecting the reactance shift comprises comparing the drain voltage to a supply voltage of the power amplifier.

Example 11 includes the method of any one of examples 9 to 10, including or excluding optional features. In this example, the power amplifier is a switch mode power amplifier.

Example 12 includes the method of any one of examples 9 to 11, including or excluding optional features. In this example, the power amplifier is a class E switch mode power amplifier.

Example 13 includes the method of any one of examples 9 to 12, including or excluding optional features. In this example, controlling the tuning control circuit comprises controling the tuning circuit to retune the transmit coil if the drain voltage is above an upper threshold or below a lower threshold. Optionally, controlling the tuning control circuit comprises adding capacitive tuning elements to the tuning circuit if the drain voltage is above the upper threshold. Optionally, controlling the tuning control circuit comprises removing capacitive tuning elements from the tuning circuit if the drain voltage is below the lower threshold.

Example 14 includes the method of any one of examples 9 to 13, including or excluding optional features. In this example, the tuning control circuit is independent of a processor.

Example 15 includes the method of any one of examples 9 to 14, including or excluding optional features. In this example, the tuning control circuit is independent of a digital representation of the drain voltage.

Example 16 includes the method of any one of examples 9 to 15, including or excluding optional features. In this example, the tuning control circuit is independent of an impedance of the transmit coil.

Example 17 is a wireless power transmitter that is re-tunable based on detecting a reactance shift. The wireless power transmitter includes a transmitter coil to generate a magnetic field for wirelessly charging a battery; a power amplifier to provide an electrical energy to the transmitter coil, the power amplifier comprising a transistor to generate the electrical energy, wherein a drain terminal of the transistor is coupled to a voltage source; a tuning control circuit comprising: a peak detection circuit to detect a peak voltage at the drain terminal; and a comparator to compare the peak voltage at the drain terminal with a voltage level of the voltage source and generate a tuning control signal based on the comparison; wherein the tuning control signal is to control the tuning circuit to retune the transmitter coil.

Example 18 includes the wireless power transmitter of example 17, including or excluding optional features. In this example, the peak voltage at the drain terminal of the transistor is proportional to a reactance shift of the transmitter coil.

Example 19 includes the wireless power transmitter of any one of examples 17 to 18, including or excluding optional features. In this example, the power amplifier is a switch mode power amplifier.

Example 20 includes the wireless power transmitter of any one of examples 17 to 19, including or excluding optional features. In this example, the power amplifier is a class E switch mode power amplifier.

Example 21 includes the wireless power transmitter of any one of examples 17 to 20, including or excluding optional features. In this example, the tuning control signal causes the tuning circuit to retune the transmitter coil if the peak voltage is above an upper threshold or below a lower threshold. Optionally, the tuning control circuit controls the tuning circuit to add capacitive tuning elements to the tuning circuit if the peak voltage is above the upper threshold. Optionally, the tuning control circuit controls the tuning circuit to remove capacitive tuning elements to the tuning circuit if the peak voltage is below the lower threshold.

Example 22 includes the wireless power transmitter of any one of examples 17 to 21, including or excluding optional features. In this example, the tuning control circuit is independent of a processor.

Example 23 includes the wireless power transmitter of any one of examples 17 to 22, including or excluding optional features. In this example, the tuning control circuit is independent of a digital representation of the drain voltage.

Example 24 includes the wireless power transmitter of any one of examples 17 to 23, including or excluding optional features. In this example, the tuning control circuit is independent of an impedance of the transmitter coil.

Example 25 is an apparatus that is re-tunable based on detecting a reactance shift of a transmit coil. The apparatus includes a transmit coil to generate a magnetic field for wirelessly charging a battery; a power amplifier to provide an electrical energy to the transmit coil, the power amplifier comprising a transistor to generate the electrical energy, wherein a drain terminal of the transistor is coupled to a voltage source; and means for detecting a reactance shift of the transmit coil by measuring a voltage at the drain terminal of the transistor; means for retuning the transmit coil in response to the reactance shift of the transmitter coil.

Example 26 includes the apparatus of example 25, including or excluding optional features. In this example, the means for detecting the reactance shift comprises means for comparing the drain voltage to a supply voltage of the power amplifier.

Example 27 includes the apparatus of any one of examples 25 to 26, including or excluding optional features. In this example, the power amplifier is a switch mode power amplifier.

Example 28 includes the apparatus of any one of examples 25 to 27, including or excluding optional features. In this example, the power amplifier is a class E switch mode power amplifier.

Example 29 includes the apparatus of any one of examples 25 to 28, including or excluding optional features. In this example, the means for retuning the transmit coil comprises means for controlling a tuning circuit to retune the transmit coil if the drain voltage is above an upper threshold or below a lower threshold. Optionally, the means for retuning the transmit coil comprises means for adding capacitive tuning elements to the tuning circuit if the drain voltage is above the upper threshold. Optionally, the means for retuning the transmit coil comprises means for removing capacitive tuning elements from the tuning circuit if the drain voltage is below the lower threshold.

Example 30 includes the apparatus of any one of examples 25 to 29, including or excluding optional features. In this example, the means for detecting the reactance shift of the transmit coil and the means for retuning the transmit coil do not include a processor.

Example 31 includes the apparatus of any one of examples 25 to 30, including or excluding optional features. In this example, the means for detecting the reactance shift of the transmit coil and the means for retuning the transmit coil do not generate a digital representation of the drain voltage.

Not all components, features, structures, characteristics, etc. described and illustrated herein need be included in a particular aspect or aspects. If the specification states a component, feature, structure, or characteristic "may", "might", "can" or "could" be included, for example, that particular component, feature, structure, or characteristic is not required to be included. If the specification or claim refers to "a" or "an" element, that does not mean there is only one of the element. If the specification or claims refer to "an additional" element, that does not preclude there being more than one of the additional element.

It is to be noted that, although some aspects have been described in reference to particular implementations, other implementations are possible according to some aspects. Additionally, the arrangement and/or order of circuit elements or other features illustrated in the drawings and/or described herein need not be arranged in the particular way illustrated and described. Many other arrangements are possible according to some aspects.

In each system shown in a figure, the elements in some cases may each have a same reference number or a different reference number to suggest that the elements represented could be different and/or similar. However, an element may be flexible enough to have different implementations and work with some or all of the systems shown or described herein. The various elements shown in the figures may be the same or different. Which one is referred to as a first element and which is called a second element is arbitrary.

It is to be understood that specifics in the aforementioned examples may be used anywhere in one or more aspects. For instance, all optional features of the computing device described above may also be implemented with respect to either of the methods or the computer-readable medium described herein. Furthermore, although flow diagrams and/or state diagrams may have been used herein to describe aspects, the techniques are not limited to those diagrams or to corresponding descriptions herein. For example, flow need not move through each illustrated box or state or in exactly the same order as illustrated and described herein.

The present techniques are not restricted to the particular details listed herein. Indeed, those skilled in the art having the benefit of this disclosure will appreciate that many other variations from the foregoing description and drawings may be made within the scope of the present techniques. Accordingly, it is the following claims including any amendments thereto that define the scope of the present techniques.

## Claims

1. A wireless power transmitter that is re-tunable based on detecting a reactance shift, comprising:

   a transmitter coil configured to generate a magnetic field for wirelessly charging a battery;
   a tuning circuit coupled to the transmitter coil configured to retune the transmitter coil in response to a reactance shift of the transmitter coil; and
   a tuning control circuit to detect the reactance shift and control the tuning circuit to retune the transmitter coil, the tuning control circuit to detect the reactance shift by measuring a drain voltage of a power amplifier.

2. The wireless power transmitter of claim 1, wherein the drain voltage is compared to a supply voltage of the power amplifier to determine the reactance shift.

3. The wireless power transmitter of claim 1 or 2, wherein the power amplifier is a switch mode power amplifier.

4. The wireless power transmitter of any one of claims 1 to 3, wherein the power amplifier is a class E switch mode power amplifier.

5. The wireless power transmitter of any one of claims 1 to 4, wherein the tuning control circuit controls the tuning circuit to retune the transmitter coil if the drain voltage is above an upper threshold or below a lower threshold.

6. The wireless power transmitter of claim 5, wherein the tuning control circuit controls the tuning circuit to add capacitive tuning elements to the tuning circuit if the drain voltage is above the upper threshold.

7. The wireless power transmitter of claim 5, wherein the tuning control circuit controls the tuning circuit to remove capacitive tuning elements to the tuning circuit if the drain voltage is below the lower threshold.

8. The wireless power transmitter of any one of claims 1 to 7, wherein the tuning control circuit is independent of a processor.

9. The wireless power transmitter of any one of claims 1 to 7, wherein the tuning control circuit is independent of a digital representation of the drain voltage.

10. The wireless power transmitter of any one of claims 1 to 7, wherein the tuning control circuit is independent of an impedance of the transmitter coil.

11. A method of re-tuning a transmit coil based on detecting a reactance shift, comprising:

generating, via a transmit coil, a magnetic field for wirelessly powering an electronic device;
detecting a reactance shift of the transmit coil by measuring a drain voltage of a power amplifier that provides power to the transmit coil; and
controlling a tuning circuit to retune the transmit coil based on the reactance shift.

12. The method of claim 11, wherein detecting the reactance shift comprises comparing the drain voltage to a supply voltage of the power amplifier.

13. An apparatus that is re-tunable based on detecting a reactance shift of a transmit coil, comprising:

a transmit coil to generate a magnetic field for wirelessly charging a battery;
a power amplifier to provide an electrical energy to the transmit coil, the power amplifier comprising a transistor to generate the electrical energy, wherein a drain terminal of the transistor is coupled to a voltage source; and
means for detecting a reactance shift of the transmit coil by measuring a voltage at the drain terminal of the transistor;
means for retuning the transmit coil in response to the reactance shift of the transmitter coil.

14. The apparatus of claim 13, wherein the means for detecting the reactance shift comprises means for comparing the drain voltage to a supply voltage of the power amplifier.

15. The apparatus of claim 13 or 14, wherein the means for detecting the reactance shift of the transmit coil and the means for retuning the transmit coil do not include a processor.

**PTU 102**

122 BLE ↔ 124 Controller

116 DC2DC

120 Tuning Control Circuit

112 Oscillator

Power Amp

Tuning Circuit

106 Resonator

114

118

110

**PRU 104**

134 Battery

108 Resonator → 128 Rectifier → 130 DC2DC → 132 Charger

136 BLE ← 138 Controller

Computing Device

126

100

FIG. 1

FIG. 2

300

FIG. 3

400

FIG. 4

```
┌─────────────────────────┐          ┌─────────────────────────────┐
│                    ⌐506 │          │                        ⌐502 │
│  Address Auto-Tuning    │          │  Detect Peak Drain Voltage  │
│  to Add More Reactance  │ ────────▶│  (Vdrain) and Supply        │◀───┐
│  Shift Compensation     │          │  Voltage (Vpa)              │    │
│                         │          │                             │    │
└─────────────────────────┘          └─────────────────────────────┘    │
              │                                     │                     │
              │                                     ▼                     │
              │                              ╱────────────╲               │
              │                            ╱          ⌐504 ╲             │
              │                          ╱                    ╲           │
              │              Y         ╱          Is            ╲         │
              └───────────────────────      Vdrain/Vpa > Th1?    ─       │
                                       ╲                        ╱         │
                                         ╲                    ╱           │
                                           ╲                ╱             │
                                             ╲────────────╱               │
                                                   │ N                    │
                                                   ▼                      │
                                            ╱────────────╲                │
                                          ╱          ⌐508 ╲              │
                                        ╱                    ╲       N    │
                                      ╱          Is            ╲          │
                                             Vdrain/Vpa < = Th2?   ───────┤
                                      ╲                        ╱          │
                                        ╲                    ╱            │
                                          ╲                ╱              │
                                            ╲────────────╱               │
                                                  │ Y                     │
                                                  ▼        ⌐510          │
                                    ┌─────────────────────────────┐      │
                                    │  Detect Peak Drain Voltage  │      │
                                    │  (Vdrain) and Supply        │──────┘
                                    │  Voltage (Vpa)              │
                                    └─────────────────────────────┘
```

500

# FIG. 5

Europäisches
Patentamt

European
Patent Office

Office européen
des brevets

# EUROPEAN SEARCH REPORT

Application Number

EP 16 19 8756

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2013/099807 A1 (WHEELAND CODY B [US] ET AL) 25 April 2013 (2013-04-25) | 1-5,8-15 | INV. H02J50/12 H03F1/56 H03F3/217 |
| Y | * figures 2,6,9 * <br> * paragraph [0054] - paragraph [0055] * <br> * paragraph [0059] - paragraph [0067] * <br> ----- | 6,7 | |
| Y | US 2013/033118 A1 (KARALIS ARISTEIDIS [US] ET AL) 7 February 2013 (2013-02-07) <br> * paragraph [0070] * <br> ----- | 6,7 | |
| Y | US 2015/123484 A1 (KURS ANDRE B [US] ET AL) 7 May 2015 (2015-05-07) <br> * figure 40 * <br> * paragraph [0393] * <br> ----- | 6,7 | |

TECHNICAL FIELDS
SEARCHED (IPC)

H02J
H03F

The present search report has been drawn up for all claims

| Place of search | Date of completion of the search | Examiner |
|---|---|---|
| Munich | 26 April 2017 | Martin, Raynald |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

EP 3 185 397 A1

## ANNEX TO THE EUROPEAN SEARCH REPORT
## ON EUROPEAN PATENT APPLICATION NO.

EP 16 19 8756

26-04-2017

| Patent document cited in search report | | Publication date | Patent family member(s) | | Publication date |
|---|---|---|---|---|---|
| US 2013099807 | A1 | 25-04-2013 | NONE | | |
| US 2013033118 | A1 | 07-02-2013 | AU | 2012289855 A1 | 13-03-2014 |
| | | | CA | 2844062 A1 | 07-02-2013 |
| | | | CN | 103843229 A | 04-06-2014 |
| | | | EP | 2764604 A2 | 13-08-2014 |
| | | | JP | 2014527793 A | 16-10-2014 |
| | | | KR | 20140053282 A | 07-05-2014 |
| | | | US | 2013033118 A1 | 07-02-2013 |
| | | | US | 2016352152 A1 | 01-12-2016 |
| | | | WO | 2013020138 A2 | 07-02-2013 |
| US 2015123484 | A1 | 07-05-2015 | US | 2012153732 A1 | 21-06-2012 |
| | | | US | 2013154389 A1 | 20-06-2013 |
| | | | US | 2015123484 A1 | 07-05-2015 |

EPO FORM P0459

For more details about this annex : see Official Journal of the European Patent Office, No. 12/82